# EUROPEAN PATENT APPLICATION

(11) **EP 4 027 378 A2**
(43) Date of publication of application: **13.07.2022**
(21) Application number: 21196781.5
(22) Date of filing: 15.09.2021
(51) Int. Cl.: H01L 23/00

(54) **POROUS FIRST LEVEL INTERCONNECT (FLI) BUMPS FOR REDUCING BUMP THICKNESS VARIATION SENSITIVITY TO ENABLE BUMP PITCH SCALING**

(30) Priority: 25.11.2020 US 202017104919
(71) Applicant: INTEL Corporation, Santa Clara, CA 95054 (US)
(72) Inventor: AHMED, Numair, Chandler, 85286 (US); LEE, Kyu Oh, Chandler, 85286 (US); MARIN, Brandon, Gilbert, 85234 (US); DUAN, Gang, Chandler, 85248 (US)
(74) Representative: 2SPL Patentanwälte PartG mbB

(57) **Abstract**

Embodiments disclosed herein include electronic packages with fin pitch first level interconnects. In an embodiment, the electronic package comprises a die and a package substrate attached to the die by a plurality of first level interconnects (FLIs). In an embodiment, individual ones of the plurality of FLIs comprise, a first pad on the package substrate, a solder on the first pad, a second pad on the die, and a bump on the second pad. In an embodiment, the bump comprises a porous nanostructure, and the solder at least partially fills the porous nanostructure.

## Description

### TECHNICAL FIELD

Embodiments of the present disclosure relate to semiconductor devices, and more particularly to electronic packages with porous first level interconnect (FLI) bumps.

### BACKGROUND

Emerging architectures for electronic systems are increasingly requiring die disaggregation and bump pitch scaling to achieve an increase in communication bandwidth between dies and attain die area savings. This requirement for scaling down bump pitch needs precise control of bump thickness variation (rBTV). To achieve good process yields, an rBTV of lower than 10µm is strongly desired, which is not trivial given that the thickness variation of standard multilayer organic substrates can be more than 40µm even before reaching the final first level interconnect (FLI) layer.

Current approaches to meet the stringent rBTV requirements for next generation architectures have primarily focused on reducing the thickness variation of the package substrate. For example, processes such as mechanical planarization, advanced lamination technologies, new tools for FLI plating uniformity improvement, and special lithography steps have been proposed. However, such processing operations are costly and complex.

### BRIEF DESCRIPTION OF THE DRAWINGS

Figure 1A is a cross-sectional illustration of a die with a nanoporous bump over a package substrate with solder on a pad, in accordance with an embodiment.
Figure 1B is a cross-sectional illustration of the die after it has been attached to the pad by the solder penetrating the nanoporous bump, in accordance with an embodiment.
Figure 2A is a cross-sectional illustration of a die with nanoporous bumps over a package substrate with a plurality of solder bumps with non-uniform bump thickness, in accordance with an embodiment.
Figure 2B is a cross-sectional illustration of the die after it has been attached to the package substrate by the solder penetrating the nanoporous bumps, in accordance with an embodiment.
Figure 3A is a micrograph of a solder between a standard bump and a standard pad, in accordance with an embodiment.
Figure 3B is a micrograph of a solder between a bump and a nanoporous pad that illustrates the penetration of the solder into the nanoporous pad, in accordance with an embodiment.
Figure 4A is a cross-sectional illustration of a bump comprising an alloyed composition, in accordance with an embodiment.
Figure 4B is a cross-sectional illustration of the bump in Figure 4A after one of the alloy constituents is removed to form a nanoporous bump, in accordance with an embodiment.
Figure 5A is a plan view scanning electron microscopy (SEM) image of a surface of a nanoporous bump, in accordance with an embodiment.
Figure 5B is a cross-sectional SEM image of a nanoporous bump, in accordance with an embodiment.
Figure 6A is a cross-sectional illustration of a die with bumps over a package substrate with nanoporous bumps over pads, in accordance with an embodiment.
Figure 6B is a cross-sectional illustration of the die attached to the package substrate by solder that penetrates the nanoporous bumps, in accordance with an embodiment.
Figure 7A is a cross-sectional illustration of a die with nanoporous bumps over a package substrate with solder over pads, in accordance with an embodiment.
Figure 7B is a cross-sectional illustration of the die attached to the package substrate by solder that penetrates the nanoporous bumps, in accordance with an embodiment.
Figure 8 is a cross-sectional illustration of an electronic system that comprise first level interconnects (FLIs) with nanoporous bumps, in accordance with an embodiment.
Figure 9 is a schematic of a computing device built in accordance with an embodiment.

### EMBODIMENTS OF THE PRESENT DISCLOSURE

Described herein are electronic packages with porous first level interconnect (FLI) bumps, in accordance with various embodiments. In the following description, various aspects of the illustrative implementations will be described using terms commonly employed by those skilled in the art to convey the substance of their work to others skilled in the art. However, it will be apparent to those skilled in the art that the present invention may be practiced with only some of the described aspects. For purposes of explanation, specific numbers, materials and configurations are set forth in order to provide a thorough understanding of the illustrative implementations. However, it will be apparent to one skilled in the art that the present invention may be practiced without the specific details. In other instances, well-known features are omitted or simplified in order not to obscure the illustrative implementations.

Various operations will be described as multiple discrete operations, in turn, in a manner that is most helpful in understanding the present invention, however, the order of description should not be construed to imply that these operations are necessarily order dependent. In particular, these operations need not be performed in the order of presentation.

As noted above, bump thickness variation (rBTV) needs to be minimized in order to allow for high yielding first level interconnects (FLIs) in advanced system architectures. Particularly, it is projected that a rBTV of approximately 10µm is needed for some applications. Current approaches for reaching such stringent rBTV values currently rely on advances to the manufacture of organic package substrates. However, such approaches are exceedingly costly.

Accordingly, embodiments disclosed herein propose another route for enabling advanced system architectures. Instead of decreasing rBTV, embodiments disclosed herein reduce or eliminate the sensitivity to rBTV for FLIs. By reducing the sensitivity to rBTV, modifications to the manufacture of the organic package substrate may not need to be made in some embodiments. Particularly, embodiments reduce the dependence on rBTV by utilizing a nanoporous bump in the FLI. In an embodiment, the solder is penetrates the internal porous structure of the nanoporous bump. Additionally, due to a high surface area, a large percentage of the solder is converted into an intermetallic compound (IMC). The solder penetration and conversion to IMCs results in a reduction in the solder spreading. For example, solder spreading may be one-third the spreading that occurs in existing FLI architectures. As such, rBTV sensitivity is reduced since excess solder does not laterally spread away from the interconnect. This allows for tight pitch FLIs that are necessary for advanced system architectures.

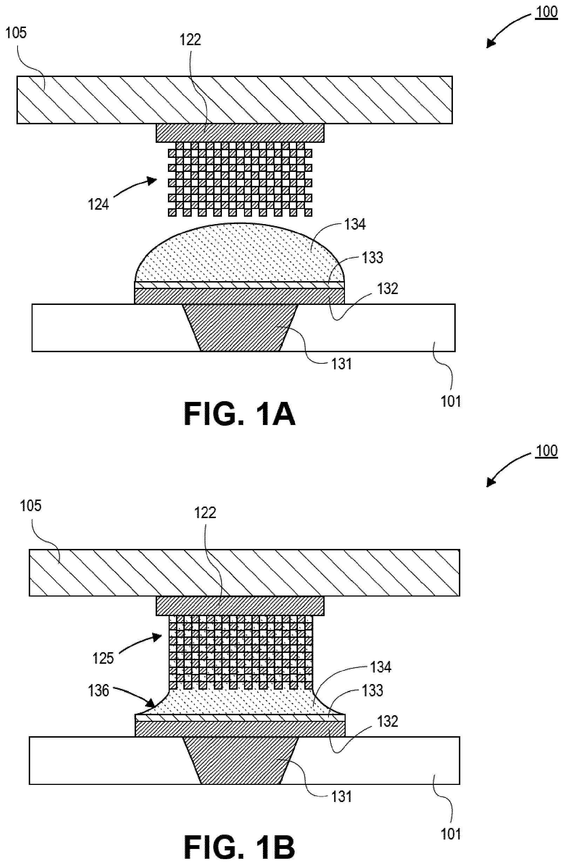

Referring now to Figure 1A, a cross-sectional illustration of an electronic package 100 before attachment of a first level interconnect (FLI) is shown, in accordance with an embodiment. As shown, a die 105 is positioned over a package substrate 101. In an embodiment, the package substrate 101 comprises laminated layers of an organic material. The package substrate 101 includes embedded conductive features, such as vias 131, traces, pads, and the like. In the illustrated embodiment, a pad 132 is provided over a top surface of the package substrate 101 and is over a via 131 that provides an electrical connection to additional conductive features (not shown) in the package substrate. In some embodiments, the pad 132 may be covered by a barrier layer 133. For example, the barrier layer 133 may comprise nickel or any other suitable barrier material or materials common in electronic packaging applications. In an embodiment, a solder bump 134 is provided over the barrier layer 133. The solder bump 134 may be any suitable solder material for electronic packaging applications, such as a tin-based solder.

In an embodiment, the die 105 may comprise a semiconductor substrate, such as, but not limited to a silicon substrate. The die 105 may comprise transistor devices (not shown) and back end of line (BEOL) routing (not shown) from the transistor devices to pads 122 on a surface of the die 105. In an embodiment, the die 105 may be a processor, a graphics processor, a system on a chip (SoC), a memory, or any other similar component.

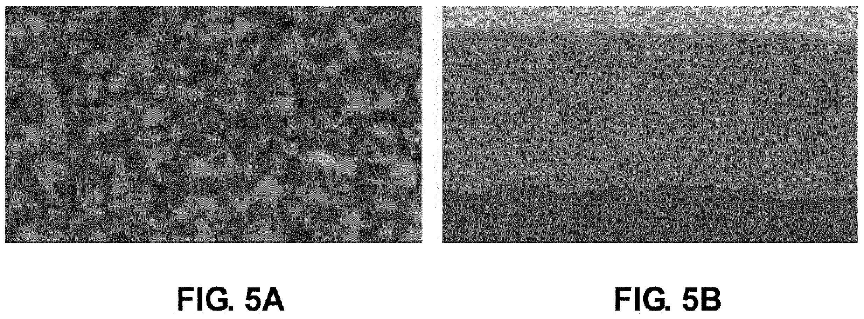

In an embodiment, a nanoporous bump 124 is provided on the pad 122. The nanoporous bump 124 extends out away from the die 105. The nanoporous bump 124 may comprise a plurality of nano-sized pores that pass through the nanoporous bump 124. In Figure 1A the nanoporous bump 124 is illustrated as having a grid-like pattern for simplicity. However, it is to be appreciated that the structure of the nanoporous bump 124 may have a non-regular structure. Exemplary micrographs of a nanoporous structure are provided in greater detail below with respect to Figures 5A and 5B. In an embodiment, the individual pores of the nanoporous structure may have an average diameter (or other cross-sectional dimension) that is between 1nm and 1000nm. In an embodiment, the nanoporous structure may comprise copper, gold, silver, cobalt, or other conductive materials that can be formed as a nanoporous architecture.

Referring now to Figure 1B, a cross-sectional illustration of the electronic package 100 after attachment of the die 105 to the package substrate 101 is shown, in accordance with an embodiment. As shown, the solder 134 penetrates the nanoporous bump 124 to form a solder filled bump 125. In the illustrated embodiment, all pores of the bump 125 are completely filled. However, in some embodiments the bump 125 may only be partially filled. Due to the high amount of surface area at the interface between the bump 125 and the solder 134, a substantial portion of the solder 134 and the bump 125 may convert to an intermetallic compound (IMC). That is, in some embodiments, the porous structure of the nanoporous bump 124 may be converted into an IMC and the pores of the nanoporous bump 124 may not be discernable in the bump 125.

The penetration of the solder 134 and the formation of IMCs is particularly beneficial in that the solder 134 is consumed or otherwise retained in the bump 125. As such, the volume of residual solder 134 is reduced and solder spreading is limited. This allows for an interconnect that is less sensitive to rBTV. In the case of a standard bump, a large rBTV may result in an excess volume of solder that must spread laterally. In embodiments disclosed herein, the excess solder from a large rBTV will be consumed or otherwise stored in the bump 125. As such, solder spreading in embodiments disclosed herein may be approximately one-third the amount of solder spreading when standard copper bumps are used.

In an embodiment, a residual portion of the solder 134 remains between the bump 125 and the barrier layer 133. In an embodiment, a profile 136 of the residual solder 134 may have a fillet shape from the edge of the barrier layer to an edge of the filled bump 125.

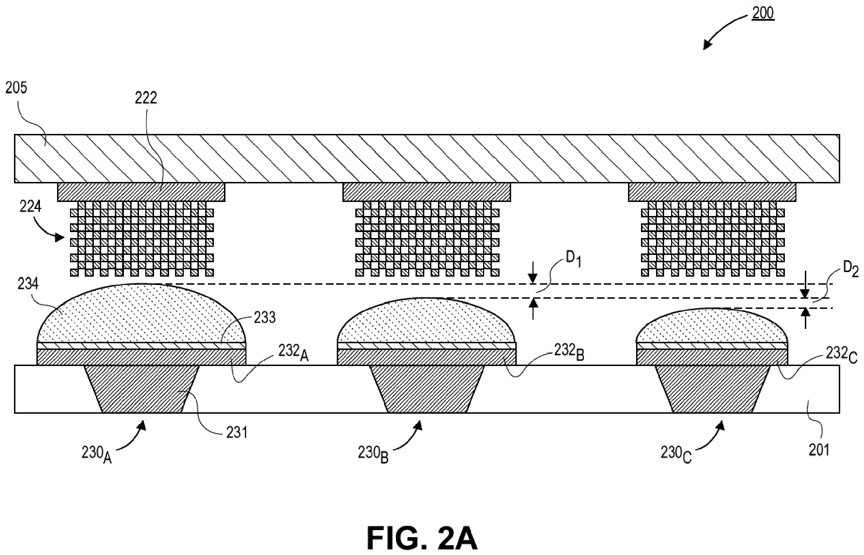

Referring now to Figure 2A, a cross-sectional illustration of an electronic package 200 is shown, in accordance with an embodiment. In an embodiment, a set of interconnects 230_{A}, 230_{B}, and 230_{C} are illustrated. Each of the interconnects comprise a via 231, a pad 232, a barrier layer 233, and a solder bump 234. In an embodiment, the diameter of the pads 232 may vary between the set of interconnects 230_{A}, 230_{B}, and 230_{C}. For example, pad 232_{A} is the largest pad, pad 232_{B} is smaller than pad 232_{A}, and pad 232_{C} is smaller than pad 232_{A}. The variation in pad diameter may result in non-uniform solder bump 234 heights. For example, a first height difference D₁ is provided between the interconnect 230_{A} and the interconnect 230_{B}, and a second height difference D₂ is provided between the interconnect 230_{B} and the interconnect 230_{C}. As such, the electronic package may be considered as having a relatively high rBTV. While not illustrated in Figure 2A, non-uniformities across the organic package substrate 201 may also add to the rBTV.

In an embodiment, a die 205 is positioned above the package substrate 201. The die 205 may comprise a plurality of pads 222 and a plurality of nanoporous bumps 224 over the pads 222. The nanoporous bumps 224 may each be aligned over one of the interconnects 230_{A}, 230_{B}, or 230_{C}. The nanoporous bumps 224 may be substantially similar to the nanoporous bump 124 described above. For example, the nanoporous bumps 224 may comprise copper, gold, silver, cobalt, or the like. Additionally, the nanoporous bumps 224 may each comprise a plurality of pores with an average cross-sectional dimension of approximately 1nm to approximately 1,000nm.

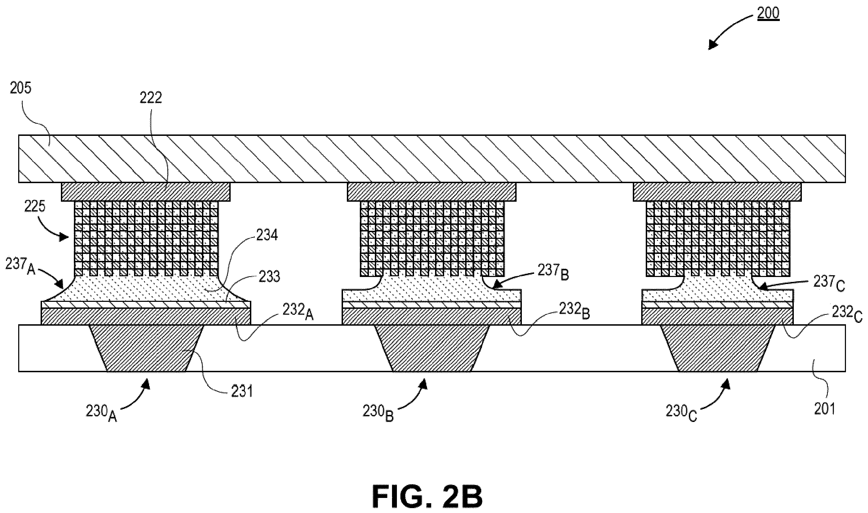

Referring now to Figure 2B, a cross-sectional illustration of the electronic package 200 after the die is brought into contact with the solder 234 is shown, in accordance with an embodiment. In an embodiment, the solder 234 may penetrate the nanoporous bumps 224 to form bumps 225 that are at least partially filled with the solder 234. The bumps 225 may further comprise IMCs resulting from the interaction of the solder 234 and the material of the nanoporous bumps 224. Due to the solder 234 penetration and conversion into IMCs, excess solder 234 resulting from the high rBTV is contained in the bumps 225 instead of spreading laterally to neighboring interconnects 230. This allows for the interconnects 230 to be provided at the fine pitches necessary for advanced system architectures. In some embodiments, the interconnects 230 may have a pitch that is between approximately 5µm and approximately 1,500µm.

In an embodiment, the residual solder 234 between the bumps 225 and the barrier layer 233 may have a fillet profile 237. Depending on the volume of the solder 234, the position of the fillet may vary. For example, in the interconnect 230_{A}. the fillet profile 237_{A} is outside of a perimeter of the bump 225, and in the interconnects 230_{B} and 230_{C}, the fillet profiles 237_{B} and 237_{C} are within the perimeter of the bumps 225.

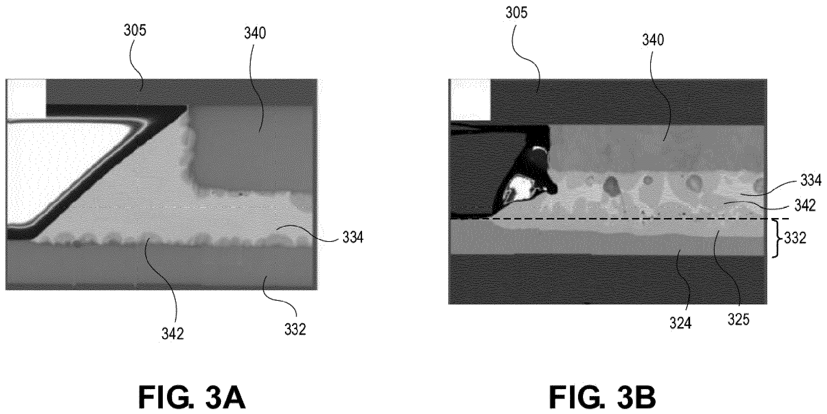

Referring now to Figures 3A and 3B, micrographs of a standard FLI interconnect (Figure 3A) and a nanoporous interconnect (Figure 3B) are shown, in accordance with an embodiment. Figures 3A and 3B are shown at approximately the same magnification and include a substantially similar volume of solder. As such, comparisons between the two Figures are able to be made.

Referring to Figure 3A, a copper bump 340 extends away from a die 305. A pad 332 is opposite from the bump 340, and a solder 334 is provided between the pad 332 and the bump 340. The pad 332 is solid copper. That is, neither the bump 340 nor the pad 332 includes a nanoporous structure. As shown, the solder 334 does not penetrate either the bump 340 or the pad 332. Additionally, only a small volume of IMC 342 is formed at the boundary between the pad 332 and the solder 334, and between the bump 340 and the solder 334.

Referring to Figure 3B, a copper bump 340 extends away from a die 305. However, instead of a solid copper pad, a nanoporous pad 332 is provided opposite from the bump 340. The dashed line indicates the original boundary where the nanoporous pad 332 ended. As shown, a filled region 325 is provided in a top half of the pad 332. This light gray region indicates that the solder 334 has penetrated the nanoporous pad 332 and converted into an IMC 342. Furthermore, it is shown that a substantial portion of the solder 334 has been converted into an IMC 342. A bottom portion 324 of the nanoporous pad 332 may be free from solder 334. That is, the solder 334 may not penetrate the entire nanoporous pad 332 in some embodiments.

In addition to the penetration and conversion to IMC, the solder 334 in Figure 3B does not expand as far laterally as the solder 334 in Figure 3A. In some embodiments, the solder 334 may expand laterally three times farther in an interconnect similar to the one in Figure 3A compared to an interconnect similar to the one in Figure 3B. Additionally, the embodiment illustrated in Figure 3B depicts a fillet like profile. While not as clean as the idealized version in the Figures above, it is to be appreciated that there is a distinct profile that is different than the nearly linear taper in the solder 334 of the interconnect illustrated in Figure 3A.

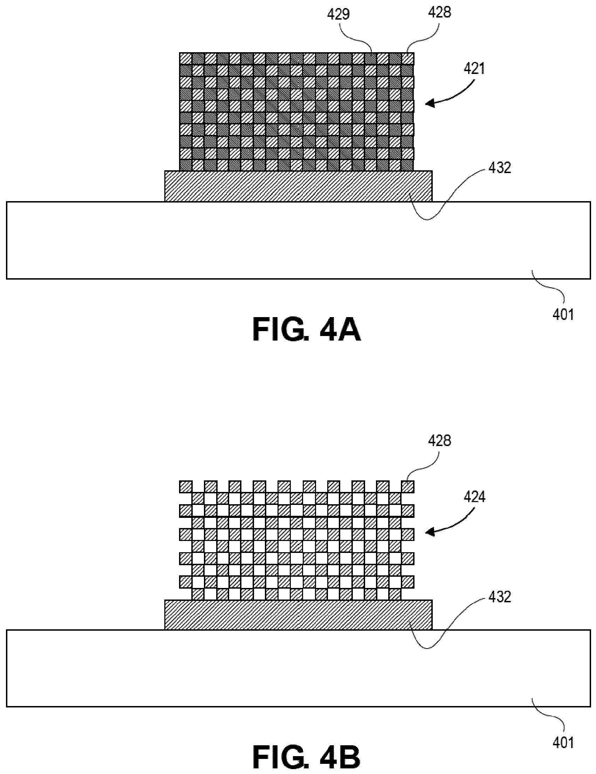

Referring now to Figures 4A and 4B, a pair of cross-sectional illustrations depicting a process for forming a nanoporous structure is shown, in accordance with an embodiment. The process depicted in Figures 4A and 4B may be referred to as a de-alloying process. While a de-alloying process is described as one method to form the nanoporous structure, it is not the only method to form such structures. For example, plating processes with controlled additives and conditions may also result in the formation of a nanoporous structure. Similarly, high pressure sputtering processes may be used to form a nanoporous structure.

Referring now to Figure 4A, an idealized depiction of a bump 421 comprising an alloy with a first constituent 428 and a second constituent 429 is shown, in accordance with an embodiment. The bump 421 may be over a pad 432, which is over a package substrate 401. However, it is to be appreciated that a de-alloying process may also be implemented on a die side bump 421 using similar processes. In Figure 4A, the first constituent 428 and the second constituent 429 are illustrated as being in a grid-like pattern for clarity. However, it is to be appreciated that the microstructure of the die side bump 421 will have a more natural distribution of the first constituent 428 mixed with the second constituent 429.

In an embodiment, the first constituent 428 and the second constituent 429 are materials that can be selectively etched with respect to each other. For example, a wet etching chemistry may be provided that selectively removes the second constituent 429 while leaving behind the first constituent 428. In a particular embodiment, the first constituent 428 may be copper and the second constituent 429 may be zinc. Other alloys are also possible, such as an alloy with gold for the first constituent 428 and silver for the second constituent 429. Additionally, while an embodiment with a pair of constituents 428 and 429 are described and illustrated, it is to be appreciated that alloys with three or more constituents may be selectively de-alloyed in a similar manner to provide a nanoporous structure.

Referring now to Figure 4B, a cross-sectional illustration of the interconnect after the de-alloying process is shown, in accordance with an embodiment. In an embodiment, the de-alloying process has resulted in the removal of the second constituent 429 in order to leave behind a nanoporous bump 424 with substantially only the first constituent 428. It is to be appreciated that in some embodiments residual portions of the second constituent 429 may remain as the etching process may not entirely remove all of the second constituent 429.

Referring now to Figures 5A and 5B, scanning electron microscopy (SEM) images of a nanoporous structure are shown, in accordance with an embodiment. Figure 5A is an image of a top surface of a nanoporous bump, and Figure 5B is a sectional image of a nanoporous bump. As shown in the images, the nanoporous structure results in a textured surface. The lighter portions of the images are the solid structure of the nanoporous bump, and the dark regions are the pores of the nanoporous bumps. As shown, the pores are substantially evenly distributed throughout the nanoporous bumps.

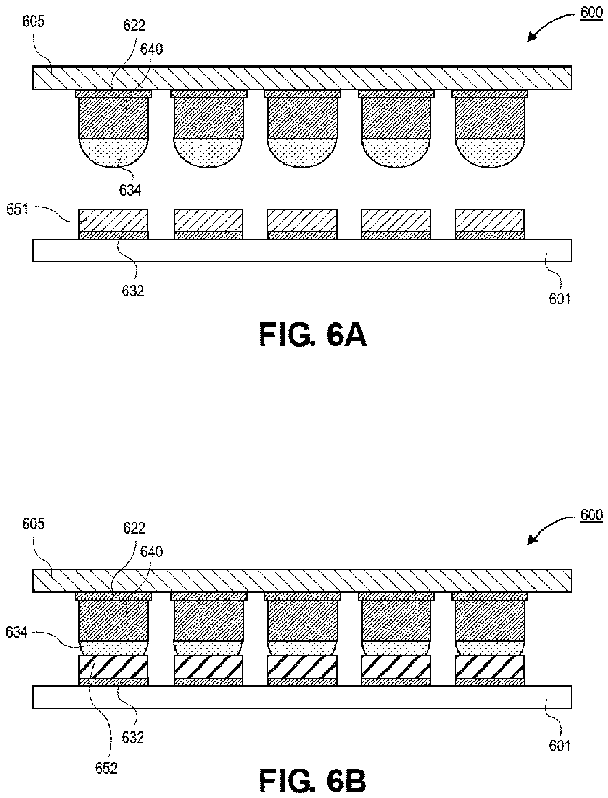

Referring now to Figures 6A and 6B a process for assembling an electronic package 600 with package side nanoporous bumps 651 is shown, in accordance with an embodiment.

Referring now to Figure 6A, a package substrate 601 is provided below a die 605. In an embodiment, the package substrate 601 may comprise organic layers with conductive routing (not shown) embedded therein. The conductive routing may be electrically connected to pads 632. The pads 632 may be any conductive material, such as copper. In an embodiment, nanoporous bumps 651 are provided over each of the pads 632. The nanoporous bumps 651 may be substantially similar to any of the nanoporous bumps described in greater detail above. For example, the nanoporous bumps 651 may comprise a conductive material with a plurality of pores through the conductive material. In an embodiment, the conductive material may comprise, copper, gold, silver, cobalt, or the like. In an embodiment, the pores may have a cross-sectional dimension that is between approximately 1nm and 1,000nm. The nanoporous bumps 651 may be fabricated over the pads 632 by processes such as, but not limited to, a de-alloying process, a controlled plating process, or a high pressure sputtering process.

In an embodiment, a die 605 is provided opposite from the package substrate 601. The die 605 may comprise transistors (not shown) that are electrically coupled to pads 622 through conductive features (not shown) in a BEOL stack. In an embodiment, bumps 640 are provided over the pads 622. The bumps 640 may be copper bumps or the like. In an embodiment, solder 634 may be provided over the bumps 640.

Referring now to Figure 6B, a cross-sectional illustration of the electronic package 600 after the die 605 is attached to the package substrate 601 is shown, in accordance with an embodiment. In an embodiment, the solder 634 may penetrate the nanoporous bumps 651 to form solder filled bumps 652. Due to the high surface area between the solder 634 and the nanoporous bumps 651, the solder filled bumps 652 may comprise a substantially large amount of IMC. In an embodiment, the solder filled bumps 652 may be substantially filled with the solder 634. That is, substantially all of the pores of the nanoporous bumps 651 may be filled with solder 634 (which may then be converted to IMC). In other embodiments, the solder 634 may not fully penetrate the nanoporous bumps 651, and the solder filled bumps 652 may maintain some open pores.

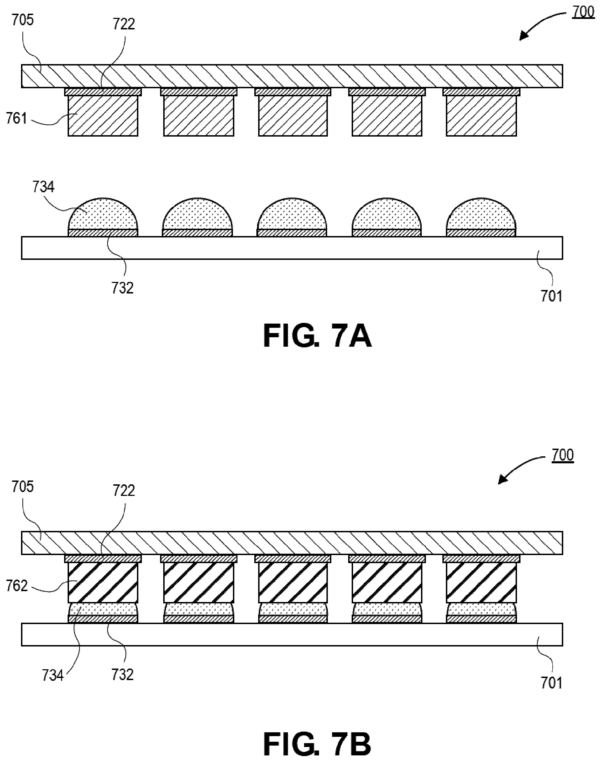

Referring now to Figures 7A and 7B, a process for assembling an electronic package 700 with die side nanoporous bumps 761 is shown, in accordance with an embodiment.

Referring now to Figure 7A, a cross-sectional illustration of an electronic package 700 with a die 705 positioned above a package substrate 701 is shown, in accordance with an embodiment. In an embodiment, the package substrate 701 may comprise organic layers with conductive routing (not shown) embedded therein. The conductive routing may be electrically connected to pads 732. The pads 732 may be any conductive material, such as copper. In an embodiment, a solder 734 is disposed over each of the pads 732.

In an embodiment, a die 705 is provided opposite from the package substrate 701. The die 705 may comprise transistors (not shown) that are electrically coupled to pads 722 through conductive features (not shown) in a BEOL stack. In an embodiment, nanoporous bumps 761 are provided over each of the pads 722. The nanoporous bumps 761 may be substantially similar to any of the nanoporous bumps described in greater detail above. For example, the nanoporous bumps 761 may comprise a conductive material with a plurality of pores through the conductive material. In an embodiment, the conductive material may comprise, copper, gold, silver, cobalt, or the like. In an embodiment, the pores may have a cross-sectional dimension that is between approximately 1nm and 1,000nm. The nanoporous bumps 761 may be fabricated over the pads 722 by processes such as, but not limited to, a de-alloying process, a controlled plating process, or a high pressure sputtering process.

Referring now to Figure 7B, a cross-sectional illustration of the electronic package 700 after the die 705 is attached to the package substrate 701 is shown, in accordance with an embodiment. In an embodiment, the solder 734 may penetrate the nanoporous bumps 761 to form solder filled bumps 762. Due to the high surface area between the solder 734 and the nanoporous bumps 761, the solder filled bumps 762 may comprise a substantially large amount of IMC. In an embodiment, the solder filled bumps 762 may be substantially filled with the solder 734. That is, substantially all of the pores of the nanoporous bumps 761 may be filled with solder 734 (which may then be converted to IMC). In other embodiments, the solder 734 may not fully penetrate the nanoporous bumps 761, and the solder filled bumps 762 may maintain some open pores.

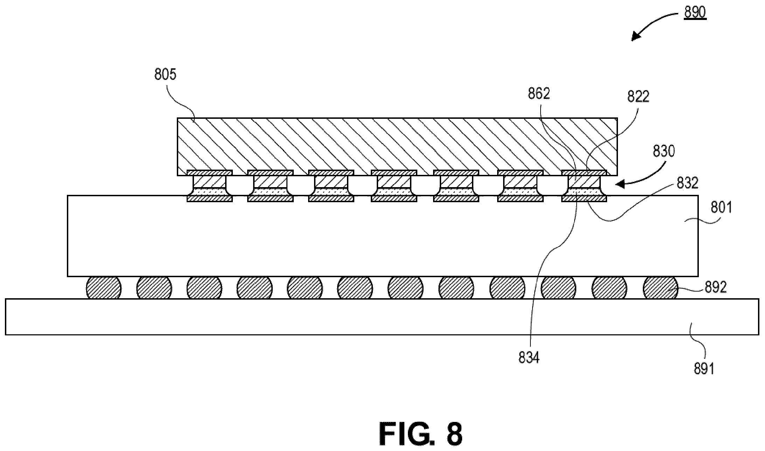

Referring now to Figure 8, a cross-sectional illustration of an electronic system 890 is shown, in accordance with an embodiment. In an embodiment, the electronic system 890 may comprise a board 891. A package substrate 801 is attached to the board 891 by interconnects 892. The interconnects 892 are shown as solder balls. However, it is to be appreciated that the interconnects 892 may comprise any suitable interconnect architecture, such as a socket or the like. In an embodiment, the package substrate 801 comprises a plurality of laminated organic layers. Conductive routing (not shown) may be electrically coupled to pads 832 on the top surface of the package substrate 801.

In an embodiment, a die 805 is electrically coupled to the package substrate by a plurality of FLIs 830. The FLIs 830 connect pads 822 on the die 805 to the pads 832 on the package substrate. In an embodiment, the FLIs 830 comprise a nanoporous bump 862 and a solder 834. The nanoporous bumps 862 may be substantially similar to any of the nanoporous bumps described in greater detail above. For example, the nanoporous bumps 862 may comprise a conductive material with a plurality of pores through the conductive material. In an embodiment, the conductive material may comprise, copper, gold, silver, cobalt, or the like. In an embodiment, the pores may have a cross-sectional dimension that is between approximately 1nm and 1,000nm. The nanoporous bumps 862 may be fabricated over the pads 822 by processes such as, but not limited to, a de-alloying process, a controlled plating process, or a high pressure sputtering process.

In an embodiment, the solder 834 may penetrate the nanoporous bumps 862 to form solder filled bumps 862. Due to the high surface area between the solder 834 and the nanoporous bumps 862, the solder filled bumps 862 may comprise a substantially large amount of IMC. In an embodiment, the solder filled bumps 862 may be substantially filled with the solder 834. That is, substantially all of the pores of the nanoporous bumps 862 may be filled with solder 834 (which may then be converted to IMC). In other embodiments, the solder 834 may not fully penetrate the nanoporous bumps 862, and the solder filled bumps 862 may maintain some open pores.

In the illustrated embodiment, the solder filled bumps 862 are on the die side of the electronic system 890. However, it is to be appreciated that the solder filled bumps 862 may alternatively be provided on the package substrate 801 side of the electronic system 890. That is, the solder filled bumps 862 may be formed over the pads 832 instead of over the pads 822.

In an embodiment, the presence of the nanoporous bumps 862 prevents the lateral spreading of the solder 834. Particularly, when excess solder 834 is present (e.g., due to a high rBTV) the excess solder 834 penetrates the nanoporous bumps 862 and converts to an IMC. As such, successful formation of the FLIs 830 is not dependent on having a low rBTV.

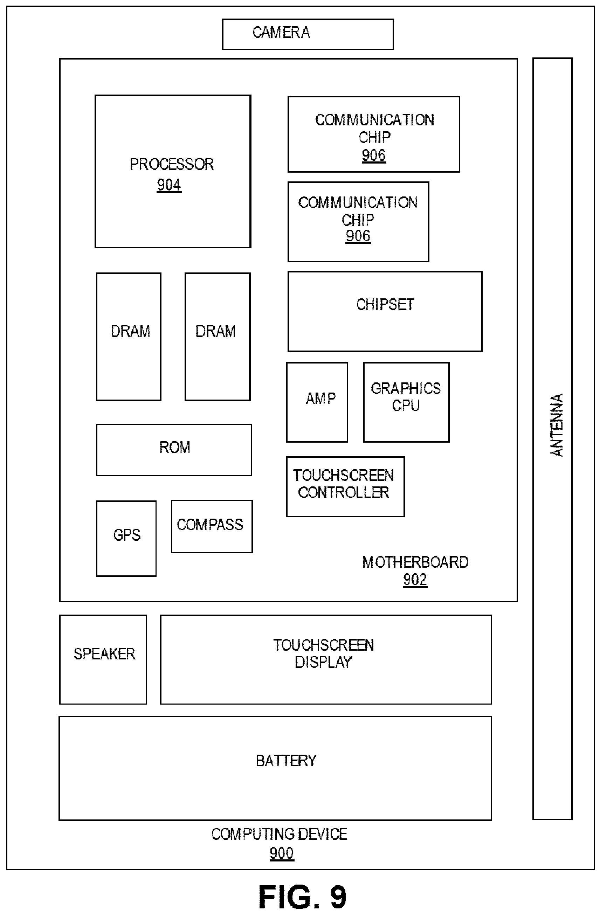

Figure 9 illustrates a computing device 900 in accordance with one implementation of the invention. The computing device 900 houses a board 902. The board 902 may include a number of components, including but not limited to a processor 904 and at least one communication chip 906. The processor 904 is physically and electrically coupled to the board 902. In some implementations the at least one communication chip 906 is also physically and electrically coupled to the board 902. In further implementations, the communication chip 906 is part of the processor 904.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 906 enables wireless communications for the transfer of data to and from the computing device 900. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 906 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 900 may include a plurality of communication chips 906. For instance, a first communication chip 906 may be dedicated to shorter range wireless communications such as Wi-Fi and Bluetooth and a second communication chip 906 may be dedicated to longer range wireless communications such as GPS, EDGE, GPRS, CDMA, WiMAX, LTE, Ev-DO, and others.

The processor 904 of the computing device 900 includes an integrated circuit die packaged within the processor 904. In some implementations of the invention, the integrated circuit die of the processor may be electrically coupled to a package substrate by FLIs that comprise nanoporous bumps that are penetrated by solder, in accordance with embodiments described herein. The term "processor" may refer to any device or portion of a device that processes electronic data from registers and/or memory to transform that electronic data into other electronic data that may be stored in registers and/or memory.

The communication chip 906 also includes an integrated circuit die packaged within the communication chip 906. In accordance with another implementation of the invention, the integrated circuit die of the communication chip may be coupled to a package substrate by FLIs that comprise nanoporous bumps that are penetrated by solder, in accordance with embodiments described herein.

The above description of illustrated implementations of the invention, including what is described in the Abstract, is not intended to be exhaustive or to limit the invention to the precise forms disclosed. While specific implementations of, and examples for, the invention are described herein for illustrative purposes, various equivalent modifications are possible within the scope of the invention, as those skilled in the relevant art will recognize.

These modifications may be made to the invention in light of the above detailed description. The terms used in the following claims should not be construed to limit the invention to the specific implementations disclosed in the specification and the claims. Rather, the scope of the invention is to be determined entirely by the following claims, which are to be construed in accordance with established doctrines of claim interpretation.
Example 1: an electronic package, comprising: a die; a package substrate attached to the die by a plurality of first level interconnects (FLIs), wherein individual ones of the plurality of FLIs comprise: a first pad on the package substrate; a solder on the first pad; a second pad on the die; and a bump on the second pad, wherein the bump comprises a porous nanostructure, and wherein the solder at least partially fills the porous nanostructure.
Example 2: the electronic package of Example 1, wherein the bump and the solder react to form an intermetallic compound.
Example 3: the electronic package of Example 1 or Example 2, wherein a portion of the solder remains between the bump and the first pad.
Example 4: the electronic package of Example 3, wherein a profile of the portion of the solder has a fillet shape between the first pad and the bump.
Example 5: the electronic package of Example 4, wherein the fillet shape is outside a footprint of the bump.
Example 6: the electronic package of Example 4, wherein the fillet shape is within a footprint of the bump.
Example 7: the electronic package of Examples 1-6, further comprising: a barrier layer between the first pad and the solder.
Example 8: the electronic package of Example 7, wherein the barrier layer comprises nickel.
Example 9: the electronic package of Examples 1-8, wherein the bump comprises copper, gold, silver, or cobalt.
Example 10: the electronic package of Examples 1-9, wherein the plurality of FLIs comprises: a first FLI, wherein the first pad of the first FLI has a first dimension; and a second FLI, wherein the first pad of the second FLI has a second dimension that is smaller than the first dimension.
Example 11: the electronic package, comprising: a die; a package substrate attached to the die by a plurality of first level interconnects (FLIs), wherein individual ones of the plurality of FLIs comprise: a first pad on the package substrate; a bump on the first pad, wherein the bump comprises a porous nanostructure; a solder on the bump, wherein the solder at least partially fills the porous nanostructure; and a second pad on the die, wherein the second pad is over the solder.
Example 12: the electronic package of Example 11, wherein the bump and the solder react to form an intermetallic compound.
Example 13: the electronic package of Example 11 or Example 12, wherein a portion of the solder remains between the bump and the second pad.
Example 14: the electronic package of Example 13, wherein a profile of the portion of the solder has a fillet shape between the first pad and the bump.
Example 15: the electronic package of Example 14, wherein the fillet shape is outside a footprint of the bump.
Example 16: the electronic package of Example 14, wherein the fillet shape is within a footprint of the bump.
Example 17: the electronic package of claim 11, further comprising: a barrier layer between the first pad and the bump.
Example 18: the electronic package of Example 17, wherein the barrier layer comprises nickel.
Example 19: the electronic package of Examples 11-18, wherein the bump comprises copper, gold, silver, or cobalt.
Example 20: a die, comprising: a substrate; a plurality of first level interconnects (FLIs) on the substrate, wherein individual ones of the FLIs comprise: a pad over the substrate; and a bump over the pad and extending away from the substrate, wherein the bump comprises a porous nanostructure.
Example 21: the die of Example 20, wherein the bump comprises copper, gold, silver, or cobalt.
Example 22: the die of Example 20 or Example 21, wherein pores of the porous nanostructure have an average diameter of approximately 1,000nm or smaller.
Example 23: an electronic system, comprising: a board; a package substrate coupled to the board; a die coupled to the package substrate by a plurality of first level interconnects (FLIs), wherein individual ones of the FLIs comprise: a bump with a porous nanostructure, wherein the porous nanostructure is at least partially filled with a solder.
Example 24: the electronic system of Example 23, wherein the bump is on the package substrate side of the FLI.
Example 25: the electronic system of Example 23, wherein the bump is on the die side of the FLI.

## Claims

1. An electronic package, comprising:
a die;
a package substrate attached to the die by a plurality of first level interconnects (FLIs), wherein individual ones of the plurality of FLIs comprise:
a first pad on the package substrate;
a solder on the first pad;
a second pad on the die; and
a bump on the second pad, wherein the bump comprises a porous nanostructure, and wherein the solder at least partially fills the porous nanostructure.

2. The electronic package of claim 1, wherein the bump and the solder react to form an intermetallic compound.

3. The electronic package of claim 1 or 2, wherein a portion of the solder remains between the bump and the first pad.

4. The electronic package of claim 3, wherein a profile of the portion of the solder has a fillet shape between the first pad and the bump.

5. The electronic package of claim 4, wherein the fillet shape is outside a footprint of the bump.

6. The electronic package of claim 4, wherein the fillet shape is within a footprint of the bump.

7. The electronic package of claim 1, 2, 3, 4, 5 or 6, further comprising:
a barrier layer between the first pad and the solder.

8. The electronic package of claim 7, wherein the barrier layer comprises nickel.

9. The electronic package of claim 1, 2, 3, 4, 5, 6, 7 or 8, wherein the bump comprises copper, gold, silver, or cobalt.

10. The electronic package of claim 1, 2, 3, 4, 5, 6, 7, 8 or 9, wherein the plurality of FLIs comprises:
a first FLI, wherein the first pad of the first FLI has a first dimension; and
a second FLI, wherein the first pad of the second FLI has a second dimension that is smaller than the first dimension.

11. A method of fabricating an electronic package, the method comprising:
attaching a package substrate attached to a die by a plurality of first level interconnects (FLIs), wherein individual ones of the plurality of FLIs comprise:
a first pad on the package substrate;
a solder on the first pad;
a second pad on the die; and
a bump on the second pad, wherein the bump comprises a porous nanostructure, and wherein the solder at least partially fills the porous nanostructure.

12. The method of claim 11, wherein the bump and the solder react to form an intermetallic compound.

13. The method of claim 11 or 12, wherein a portion of the solder remains between the bump and the first pad.

14. The method of claim 13, wherein a profile of the portion of the solder has a fillet shape between the first pad and the bump.

15. The method of claim 14, wherein the fillet shape is outside a footprint of the bump.
